# DEMANDE DE BREVET EUROPEEN

(11) **EP 4 517 757 A1**
(43) Date de publication de la demande: **05.03.2025**
(21) Numéro de dépôt: 24195497.3
(22) Date de dépôt: 20.08.2024
(51) Int. Cl.: G11C 13/00

(54) **PROCÉDÉ D'ÉCRITURE DANS UNE MÉMOIRE À CHANGEMENT DE PHASE**

(30) Priorité: 31.08.2023 FR 2309151
(71) Demandeur: STMicroelectronics International N.V., 1228 Plan-les-Ouates, Geneva (CH)
(72) Inventeur: DOCQUIER, Guillaume, 4300 WAREMME (BE); NICOLAES, Michael, 1190 FOREST (BE)
(74) Mandataire: Cabinet Beaumont

(57) **Abrégé**

La présente description concerne un procédé d'écriture d'un premier groupe de N données, N étant un entier, dans un deuxième groupe (300) de N cellules mémoire (C(i)) d'une mémoire à changement de phase, dans lequel chaque donnée dudit premier groupe comprend une métadonnée (302), dans lequel à chaque écriture d'une donnée dudit premier groupe dans une cellule mémoire (C(i)) dudit deuxième groupe, la valeur de ladite métadonnée (302) de ladite donnée est modifiée.

## Description

### Domaine technique

La présente description concerne de façon générale les circuits et dispositifs électroniques, et, en particulier, les mémoires. La présente description se rapporte plus précisément aux mémoires à changement de phase, et aux procédés d'écriture de données dans des mémoires à changement de phase.

### Technique antérieure

Le stockage de données est un enjeu industriel majeur. Il existe différents types de technologies permettant de stocker des données.

Les mémoires à changement de phase sont des mémoires non volatiles qui stockent des données en modifiant l'état d'un matériau compris dans chaque point mémoire de la mémoire.

Il serait souhaitable de pouvoir améliorer, au moins en partie, certains aspects des mémoires à changement de phase, et, en particulier, certains aspects des procédés d'écriture de données dans des mémoires à changement de phase.

### Résumé de l'invention

Il existe un besoin pour des mémoires à changement de phase plus performantes.

Il existe un besoin pour des mémoires à changement de phase ayant une meilleure endurance, c'est-à-dire ayant une durée de vie plus longue.

Il existe un besoin pour des procédés d'écriture de données dans des mémoires à changement de phase plus performants.

Il existe un besoin pour des procédés d'écriture de données dans des mémoires à changement de phase présentant une meilleure endurance.

Un mode de réalisation pallie tout ou partie des inconvénients des procédés connus d'écriture de données dans des mémoires à changement de phase.

Un mode de réalisation prévoit un procédé d'écriture d'un premier groupe de N données, N étant un entier, dans un deuxième groupe de N cellules mémoire d'une mémoire à changement de phase, dans lequel chaque donnée dudit premier groupe comprend une métadonnée, dans lequel à chaque écriture d'une donnée dudit premier groupe dans une cellule mémoire dudit deuxième groupe, la valeur de ladite métadonnée de ladite donnée est modifiée.

Selon un mode de réalisation, à la fin d'un cycle d'écriture toutes les métadonnées desdites N données ont la même valeur.

Selon un mode de réalisation, la métadonnée est un bit de séquençage.

Selon un mode de réalisation, chaque cellule mémoire dudit deuxième groupe comprend plusieurs points mémoire adaptés à stocker chacun un bit de donnée.

Selon un mode de réalisation, chaque donnée dudit premier groupe est un mot de donnée comprenant plusieurs bits de donnée.

Un autre mode de réalisation prévoit un dispositif adapté à mettre en oeuvre le procédé décrit précédemment, et comprenant une mémoire à changement de phase.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente très schématiquement et sous forme de blocs, un mode de réalisation d'un dispositif électronique adapté à mettre en oeuvre le mode de mise en oeuvre du procédé de la figure 3 ;
la figure 2 représente, sous forme de blocs, une donnée à écrire dans une mémoire à changement de phase ; et
la figure 3 représente, sous forme de blocs, des étapes d'un mode de mise en oeuvre d'un procédé d'écriture de données dans une mémoire à changement de phase.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Les modes de réalisation décrits ci-après concernent un procédé d'écriture d'un groupe de données dans des cellules mémoire d'une mémoire à changement de phase permettant d'améliorer l'endurance et, ainsi, la durée de vie de la mémoire à changement de phase. Pour cela, chaque donnée du groupe de données comprend une métadonnée dont la valeur est modifiée à chaque mise en oeuvre du procédé d'écriture.

L'utilisation de cette métadonnée, et, plus particulièrement, la modification de sa valeur à chaque écriture, permet d'éviter l'utilisation d'une étape d'effacement de la cellule mémoire, c'est-à-dire une étape pendant laquelle la cellule mémoire est repassée à un état où tous ses bits sont à une valeur de référence, par exemple la valeur "un". Cela permet de réduire le nombre d'opérations réalisées pendant un cycle d'écriture et/ou d'effacement de la mémoire, ce qui permet d'augmenter la durée de vie de la mémoire.

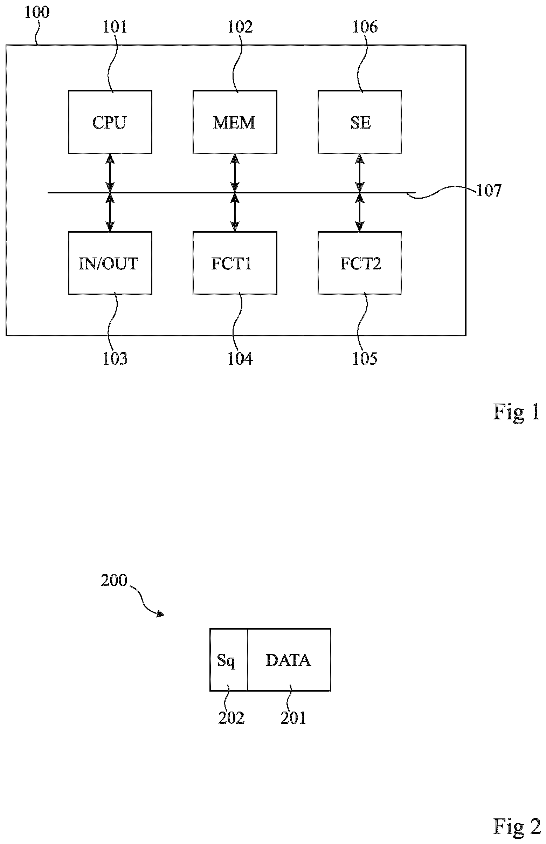

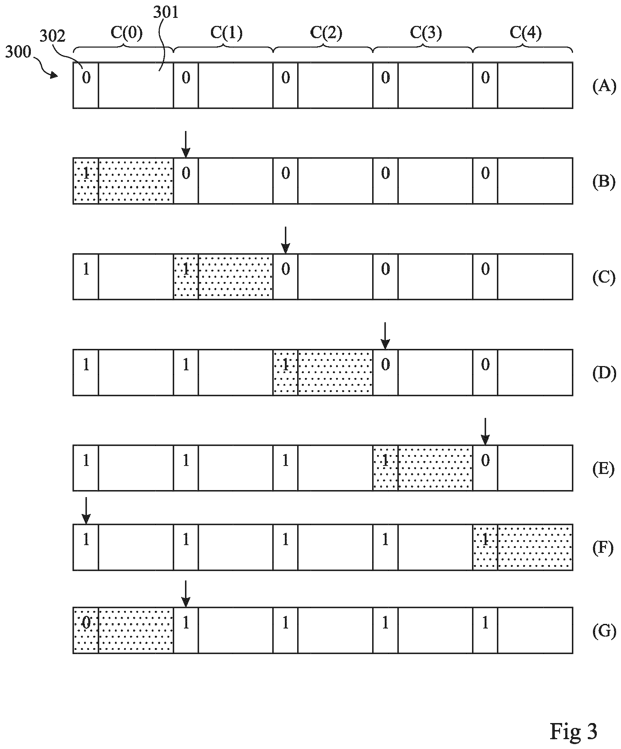

La figure 1 est un schéma bloc représentant, très schématiquement, une architecture d'un exemple d'un dispositif électronique 100 adapté à mettre en oeuvre les modes de réalisation décrits en relation avec les figures 2 et 3.

Le dispositif électronique 100 peut comprendre un processeur 101 (CPU) adapté à mettre en oeuvre différents traitements de données stockées dans des mémoires et/ou fournies par d'autres circuits du dispositif 100.

Le dispositif électronique 100 peut comprendre, en outre, un ou plusieurs de mémoires 102 (MEM), par exemple des mémoires de différents types, parmi lesquelles, par exemple, une mémoire non volatile, une mémoire volatile, et/ou une mémoire morte.

Selon un mode de réalisation, le dispositif électronique 100 comprend une mémoire à changement de phase (Phase Change Memory), ou mémoire PCM. Selon un mode de réalisation une mémoire à changement de phase est une mémoire non volatile.

On appelle dans la suite de cette description, un point mémoire d'une mémoire à changement de phase, une unité de mémoire permettant de stocker une information binaire, c'est-à-dire un bit de donnée, c'est-à-dire un "un" ou un "zéro".

On appelle dans la suite de cette description, une cellule mémoire d'une mémoire à changement de phase, un ensemble de plusieurs points mémoire permettant de stocker plusieurs bits de données. Selon un mode de réalisation, chaque cellule mémoire est adaptée à stocker une donnée, ou mot de donnée, composées de plusieurs bits de données.

Le dispositif électronique 100 comprend, en outre, par exemple, un élément sécurisé 103 (SE) adapté à traiter des données sensibles et/ou secrètes. L'élément sécurisé 103 peut comprendre son ou ses propres processeurs, sa ou ses propres mémoires, etc.

Le dispositif électronique 100 comprend, en outre, des circuits d'entrée/sortie 104 (IN/OUT) adaptés à permettre au dispositif 100 de communiquer avec un ou plusieurs dispositifs électroniques extérieurs.

Le dispositif électronique 100 peut comprendre, en outre, différents circuits 105 (FCT1) et 106 (FCT2) adaptés à réaliser différentes fonctions. A titre d'exemple, les circuits 105 et 106 peuvent comprendre des circuits de mesure, des circuits de conversion de données, des circuits de commande d'équipement électronique ou électromécanique, etc.

Le dispositif électronique 100 comprend, en outre, un ou plusieurs bus de données 107 adaptés à transférer des données entre ses différents composants.

La figure 2 représente, très schématiquement et sous forme de blocs, une donnée 200 adaptée à être écrite dans une cellule mémoire d'une mémoire à changement de phase.

La donnée 200 est un mot de donnée comprenant plusieurs bits de données comme défini précédemment.

Selon un mode de réalisation, la donnée 200 comprend des bits 201 (DATA) stockant un mot de donnée, et une métadonnée 202 (Sq).

Selon un mode de réalisation, la métadonnée 202 est un ou plusieurs bits, de préférence un bit. Selon un mode de réalisation préféré, la métadonnée 202 est un bit de séquençage. L'utilisation d'un bit de séquençage, à l'inverse de l'utilisation d'un bit d'effacement mis à jour à chaque opération d'effacement, permet de préserver la durée de vie de la mémoire. En effet, la modification d'un bit d'effacement aurait lieu deux fois pendant une opération d'écriture, alors que la modification du bit de séquençage n'a lieu qu'une seule fois. Selon un exemple, la métadonnée 202 fait partie des bits de poids fort de la donnée 200. L'utilisation de la métadonnée 202 est décrite en relation avec la figure 3.

La figure 3 représente, très schématiquement et sous forme de blocs, la mise en oeuvre d'un procédé d'écriture d'un groupe de N données, N étant un entier, du type de la donnée 200 décrite en relation avec la figure 2 dans un groupe 300 de N cellules mémoire d'une mémoire à changement de phase.

On considère un groupe 300 de cellules mémoire C(i), i étant un entier variant de 0 à N-1. Dans l'exemple de la figure 3, le groupe 300 comprend cinq cellules mémoire C(0) à C(4).

Comme décrit précédemment, chaque cellule mémoire C(i) est adaptée à stocker une donnée du type de la donnée 200 de la figure 2. Ainsi, chaque cellule mémoire C(i) stocke un mot de donnée 301 et une métadonnée 302. Pour cela, chaque cellule mémoire C(i) comprend assez de points mémoire pour stocker tous les bits de données formant une donnée.

A un état initial (A), toutes les cellules mémoire du groupe 300 sont prêtes à stocker des données. Selon un exemple, toutes les cellules mémoire du groupe 300 sont à un état vierge, et stockent toutes une même donnée, par exemple une donnée de référence comme une donnée égale à un zéro binaire. Selon un autre exemple, toutes les cellules mémoire du groupe 300 stockent déjà des données qui ont été écrites en utilisant le procédé décrit ici.

Selon un mode de réalisation, à l'état initial (A), toutes les cellules mémoire du groupe 300 stockent des données dont les métadonnées ont une même valeur. Selon un mode de réalisation préféré, la métadonnée est un bit de séquençage, et dans le cas représenté en figure 1, le bit de séquençage est à zéro.

A un état (B), consécutif à l'état initial (A), un cycle d'écriture commence par l'écriture d'une première donnée dans une première cellule mémoire du groupe 300, ici la cellule mémoire C(0). Une donnée du groupe de données est écrite dans la partie de la cellule mémoire stockant le mot de donnée 301, et, selon un mode de réalisation, la valeur de la métadonnée 302 est modifiée une seule fois.

A un état (C), consécutif à l'état (B), le cycle d'écriture continue par l'écriture d'une deuxième cellule mémoire du groupe 300, ici la cellule mémoire C(1). Ainsi, une autre donnée du groupe de données est écrite dans la partie de la cellule mémoire stockant le mot de donnée 301 de la donnée, et la valeur de la métadonnée 302 de la donnée est modifiée.

De même, le cycle d'écriture continue par l'écriture d'une donnée dans chaque cellule mémoire du groupe 300, en modifiant, pour chaque cellule mémoire, la valeur de la métadonnée 302 de la donnée. Ainsi, les états (D), (E) et (F) représentent l'écriture des autres cellules mémoire du groupe 300, et plus particulièrement, la modification de la valeur de leurs métadonnées 302.

L'état (F) représente l'état final du cycle d'écriture. Toutes les cellules mémoire du groupe 300 ont été écrites, et stockent toutes une donnée. Toutes les métadonnées des cellules mémoire C(i) ont la même valeur, c'est-à-dire ici la valeur un.

A un état (G), consécutif à l'état (F), un nouveau cycle d'écriture peut commencer, et la cellule C(0) est la première à être écrite.

Un avantage d'utiliser des métadonnées pendant un cycle d'écriture, est qu'il permet de visualiser quelle cellule mémoire a été écrite en dernier. En particulier, si un cycle d'écriture est interrompu, il suffit de trouver deux cellules mémoire consécutives n'ayant pas la même valeur de métadonnée pour savoir à quel moment le cycle a été interrompu.

Un autre avantage de ce mode de réalisation est qu'il permet de mettre en oeuvre des cycles d'écriture de données sur des parties de mémoire, c'est-à-dire un nombre de cellules mémoire défini. Il peut permettre de mettre en oeuvre un système d'écriture par page, comme utilisé avec les mémoires non volatile de type flash, ou de type eSTM, c'est-à-dire les mémoires de type Embedded Select in Trench Memory (eSTM), ou mémoires à sélection embarquée de tranchée.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé d'écriture d'un premier groupe de N données (200), N étant un entier, dans un deuxième groupe (300) de N cellules mémoire (C(i)) d'une mémoire à changement de phase (102), dans lequel chaque donnée (200) dudit premier groupe comprend une métadonnée (202 ; 302), dans lequel à chaque écriture d'une donnée (200) dudit premier groupe dans une cellule mémoire (C(i)) dudit deuxième groupe, la valeur de ladite métadonnée (202 ; 302) de ladite donnée est modifiée.

2. Procédé selon la revendication 1, dans lequel à la fin d'un cycle d'écriture toutes les métadonnées (202 ; 302) desdites N données ont la même valeur.

3. Procédé selon la revendication 1 ou 2, dans lequel la métadonnée (202 ; 302) est un bit de séquençage.

4. Procédé selon l'une quelconque des revendications 1 à 3, dans lequel chaque cellule mémoire (C(i)) dudit deuxième groupe (300) comprend plusieurs points mémoire adaptés à stocker chacun un bit de donnée.

5. Procédé selon l'une quelconque des revendications 1 à 4, dans lequel chaque donnée (200) dudit premier groupe est un mot de donnée comprenant plusieurs bits de donnée.

6. Dispositif (100) adapté à mettre en oeuvre le procédé selon l'une quelconque des revendications 1 à 5, et comprenant une mémoire à changement de phase (102).
